# EUROPEAN PATENT SPECIFICATION

(11) **EP 3 806 615 B1**
(45) Date of publication and mention of the grant of the patent: **02.08.2023**
(21) Application number: 18921387.9
(22) Date of filing: 29.06.2018
(51) Int. Cl.: H05K 13/00, H05K 13/08

(54) **TEMPORARY HOLDING AREA LOCATION DETERMINATION METHOD AND TEMPORARY HOLDING AREA LOCATION DETERMINATION DEVICE FOR BACKUP DEVICE**
VERFAHREN ZUR BESTIMMUNG DES STANDORTS EINES TEMPORÄREN AUFBEWAHRUNGSBEREICHS UND VORRICHTUNG ZUR BESTIMMUNG DES STANDORTS EINES TEMPORÄREN AUFBEWAHRUNGSBEREICHS FÜR BACKUP-VORRICHTUNG
PROCÉDÉ DE DÉTERMINATION D'EMPLACEMENT DE ZONE DE MAINTIEN TEMPORAIRE ET DISPOSITIF DE DÉTERMINATION D'EMPLACEMENT DE ZONE DE MAINTIEN TEMPORAIRE DESTINÉS À UN DISPOSITIF DE SECOURS

(30) Priority: 05.06.2018 JP 2018108104
(43) Date of publication of application: 14.04.2021
(73) Proprietor: Fuji Corporation, Chiryu-shi, Aichi 472-8686 (JP)
(72) Inventor: IISAKA Jun, Chiryu-shi, Aichi 472-8686 (JP); KOBAYASHI Haruna, Chiryu-shi, Aichi 472-8686 (JP); OYAMA Shigeto, Chiryu-shi, Aichi 472-8686 (JP)
(74) Representative: Grünecker Patent- und Rechtsanwälte PartG mbB
(86) International application number: PCT/JP2018/024816
(87) International publication number: WO 2019/234943

(56) References cited:
- EP-A1- 2 127 800
- WO-A1-2013/114478
- JP-A- 2011 009 470
- JP-A- 2011 014 627
- JP-A- 2011 014 627
- US-A1- 2014 201 998

## Description

### Technical Field

The present specification relates to a temporary storage area position determination method and a temporary storage area position determination device for determining a temporary storage area position which is a position of a temporary storage area which temporarily stores a backup member of a backup device for supporting a board.

### Background Art

As one type of a temporary storage area position determination method and a temporary storage area position determination device for a backup device, a method and device disclosed in Patent Literature 1 are known. As illustrated in Fig. 6A of Patent Literature 1, in a temporary storage area position determination method and a temporary storage area position determination device, a stock area is provided, in which multiple backup members supporting a printed circuit board are erected on a backup base, or when the backup member is removed from the backup base, a stock area is provided, in which the backup member without any printed circuit board supported is erected, an area of the backup base where the printed circuit board being not placed.

### Patent Literature

Patent Literature 1: JP-A-2011-014627

### Summary of the Invention

### Technical Problem

In the temporary storage area position determination method and the temporary storage area position determination device for the backup device described in Patent Literature 1, it is demanded to shorten a movement time when the backup member moves between the temporary storage area and a support position of the backup member.

US 2014/201998 A1 discloses techniques for arraying lower receiving pins in a lower receiving base in an electronic parts mounting apparatus.

In consideration of the circumstances, the present specification discloses a temporary storage area position determination method and a temporary storage area position determination device for a backup device capable of shortening a movement time when a backup member moves between a temporary storage area and a support position of the backup member.

### Solution to Problem

The invention is set out in the appended set of claims

### Advantageous Effect of the Invention

According to the temporary storage area position determination method for the backup device, the first step determines the second direction position of the temporary storage area based on the length of the board in the second direction. Therefore, the second direction position of the temporary storage area can be set to an appropriate position of the board in the second direction, based on the length in the second direction of the board. As a result, it is possible to shorten a movement time of the backup member between the temporary storage area and the support position of the backup member.

According to the temporary storage area position determination device, the determination section determines the second direction position of the temporary storage area based on the length of the board in the second direction. Therefore, the same effect as those of the temporary storage area position determination method for the backup device can be obtained.

### Brief Description of Drawings

Fig. 1 is a top view illustrating component mounter 10 to which a temporary storage area position determination method and a temporary storage area position determination device for a backup device are applied.
Fig. 2 is a sectional view including backup device 30 illustrated in Fig. 1.
Fig. 3 is a block diagram illustrating control device 60 illustrated in Fig. 1.
Fig. 4 is a top view illustrating an example of temporary storage area A1 and initial mounting area A2 in a case where a length of board S in a second direction is longer than a length of temporary storage area A1 in the second direction.
Fig. 5 is a top view illustrating a relationship between a range which divides the length of board S in the second direction in a stepwise manner and a setting position of temporary storage area A1.
Fig. 6 is a top view illustrating the relationship between the range which divides the length of board S in the second direction in a stepwise manner and the setting position of temporary storage area A1.
Fig. 7 is a top view illustrating the relationship between the range which divides the length of board S in the second direction in a stepwise manner and the setting position of temporary storage area A1.
Fig. 8 is a top view illustrating the relationship between the range which divides the length of board S in the second direction in a stepwise manner and the setting position of temporary storage area A1.
Fig. 9 is a top view illustrating an example of temporary storage area A1 and initial mounting area A2 in a case where the length of board S in the second direction is equal to or less than the length of temporary storage area A1 in the second direction.
Fig. 10 is a flowchart illustrating a program executed by control device 60 illustrated in Fig. 1.

### Description of Embodiments

Hereinafter, component mounter 10 to which a temporary storage area position determination method and a temporary storage area position determination device for a backup device are applied will be described.

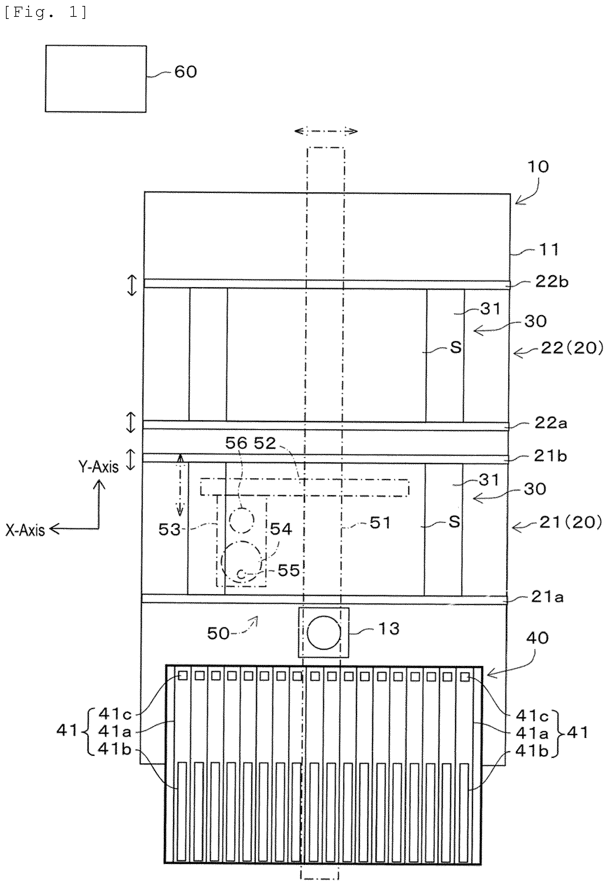

As illustrated in Fig. 1, component mounter 10 is a component mounter of a so-called double truck conveyor system, and has base 11. Component mounter 10 includes board conveyance device 20, backup device 30, component supply device 40, component transfer device 50, and control device 60 (temporary storage area position determination device).

Board conveyance device 20 conveys board S along an X-axis direction (refer to Fig. 1) which is a predetermined direction. Backup device 30 positions and fixes conveyed board S in cooperation with board conveyance device 20. Component supply device 40 is provided on one side (or both sides) of board conveyance device 20 and supplies a component (for example, electronic component) to be mounted on board S. Component transfer device 50 is disposed above devices 20, 30, and 40, picks up and holds the component, which is supplied by component supply device 40, by suction nozzle 55, and automatically mounts picked-up and held component on board S which is supported to be positioned on board conveyance device 20.

Board conveyance device 20 is a so-called double-track conveyor system, and includes first and second conveyors 21 and 22 assembled in parallel with each other on base 11.

As illustrated in Fig. 1, first conveyor 21 includes first and second guide rails 21a and 21b which are a pair of guide rails. First and second guide rails 21a and 21b extend along a first direction (X-axis direction) which is a direction (conveyance direction) in which board S is conveyed and can move relative to each other along a second direction (Y-axis direction) orthogonal to the first direction.

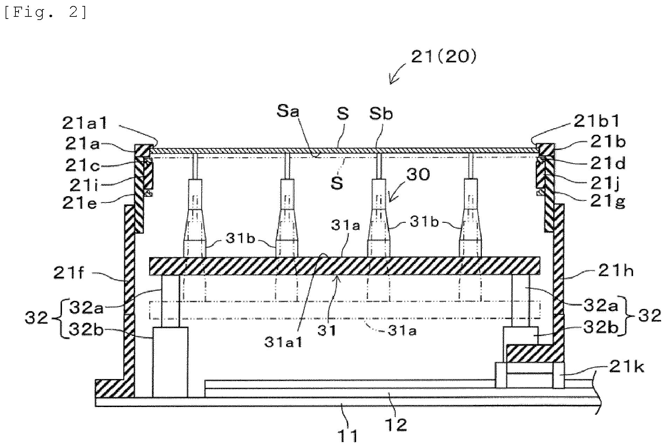

First and second guide rails 21a and 21b are disposed to face each other in parallel and guide board S in the conveyance direction. As illustrated in Fig. 2, locking section 21a1 and 21b1 which protrudes inward are provided along a longitudinal direction (conveyance direction) on each upper end of first and second guide rails 21a and 21b. First and second conveyor belts 21c and 21d provided parallel to each other immediately below first and second guide rails 21a and 21b are arranged side by side in first conveyor 21. First and second conveyor belts 21c and 21d support board S and convey board S in the conveyance direction.

Mainly as illustrated in Fig. 2, first guide rail 21a and first conveyor belt 21c of first conveyor 21 is attached to elongated first mounting frame 21e extending along the X-axis direction. Both ends of first mounting frame 21e is fixed to base 11 via pair of fixed support frames 21f. Moreover, second guide rail 21b and second conveyor belt 21d of first conveyor 21 is attached to elongated second mounting frame 21g extending along the X-axis direction. Both ends of second mounting frame 21g are respectively fixed to pair of sliders 21k, which is movable on pair of rails 12 fixed to base 11, via pair of moving support frames 21h. Rail 12 extends along the X-axis direction.

Accordingly, second guide rail 21b is positioned and fixed to move along the Y-axis direction together with second conveyor belt 21d immediately below second guide rail 21b. Therefore, first conveyor 21 can change a conveyor width (width in the Y-axis direction) corresponding to a board width (board width in the Y-axis direction) of board S to be conveyed. First and second support plates 21i and 21j, which respectively abut on lower surfaces of first and second conveyor belts 21c and 21d to support first and second conveyor belts 21c and 21d, are attached to first and second mounting frames 21e and 21g.

As illustrated in Fig. 1, similarly to first conveyor 21, second conveyor 22 includes first and second guide rails 22a and 22b which are a pair of guide rails. First and second guide rails 22a and 22b extend along the first direction (X-axis direction) which is a direction (conveyance direction) in which board S is conveyed and are relative movable to each other along the second direction (Y-axis direction) orthogonal to the first direction. Similarly to second guide rail 21b of first conveyor 21, first and second guide rails 22a and 22b are movable along the Y-axis direction. In this way, first and second guide rails 22a and 22b are positioned and fixed to move along the Y-axis direction together with first and second conveyor belts (not illustrated) immediately below first and second guide rails 22 and 22b. Therefore, second conveyor 22 can change the conveyor width (width in the Y-axis direction) corresponding to the board width (board width in the Y-axis direction) of the board S to be conveyed.

As illustrated in Figs. 1 and 2, base 11 includes backup device 30 which pushes up board S conveyed to a predetermined mounting position by board conveyance device 20 and clamps (support to position) board S. Backup device 30 supports board S from support surface Sa on a side opposite to component mounting surface Sb on which the component is mounted when the component is mounted on board S which is conveyed by pair of guide rails 21a and 21b. Backup device 30 includes board support unit 31 which supports board S, and lifting and lowering device 32 which lifts and lowers board support unit 31.

Board support unit 31 includes backup plate 31a and multiple backup pins 31b. Backup plate 31a can reciprocate relative to support surface Sa while facing support surface Sa of board S. Backup plate 31a is formed in a rectangular plate shape, for example. Backup pins 31b are multiple backup members which can be attached or detached from facing surface 31a1 of backup plate 31a facing support surface Sa of board S and support surface Sa of board S. For example, a magnet is provided in a lower section (base section) of backup pin 31b, and thus, backup pin 31b can be attached to or detached from facing surface 31a1 by a magnetic force. Backup pin 31b includes a hard-type backup pin (illustrated in Fig. 2) of which distal end section is formed of a relatively hard member (for example, a metal member) or a soft-type backup pin (not illustrated) of which distal end portion is formed of a relatively soft member (for example, a rubber member).

Incidentally, board support unit 31 may be configured to include a rectangular backup plate in which multiple holes are formed on an upper surface thereof, and a backup pin (backup member) which is erected to be inserted into or removed from each hole and supports board S.

For example, lifting and lowering device 32 is constituted by an air cylinder, and includes rods 32a which are detachably assembled to four corners of backup plate 31a, and cylinder main body 32b which moves each rod 32a forward or rearward.

Backup device 30 configured in this way holds board support unit 31 at a lowered position (illustrated by a two-dot chain line in Fig. 2) when the component is not mounted. Meanwhile, when the component is mounted, that is, when board S is conveyed to a predetermined mounting position by board conveyance device 20 and stopped (illustrated by a solid line in Fig. 1 and the two-dot chain line in Fig. 2), backup device 30 lifts board support unit 31 by lifting and lowering device 32, and pushed up board S from below and holds board S at a lifted position (illustrated by a solid line in Fig. 2). Then, when the mounting of the component is completed, backup device 30 lowers board support unit 31 to the lowered position by lifting and lowering device 32.

As illustrated in Fig. 1, in component mounter 10, component supply device 40 is disposed on one side (or both sides) of board conveyance device 20. Component supply device 40 is configured by arranging multiple component supply cassettes 41 which can be attached and detached in parallel. Component supply cassette 41 includes main body 41a, supply reel 41b which is provided in a rear section of main body 41a, and component take-out section 41c which is provided in a distal end portion of main body 41a. The components are sealed in supply reel 41b at a predetermined pitch, and an elongated tape (not illustrated) is wound and held. Component supply cassette 41 draws the tape at a predetermined pitch and subsequently feeds the component to component take-out section 41c. Component supply device 40 is not limited to a cassette type device, but may also be a tray type device in which components are arranged in a tray.

As illustrated in Fig. 1, in component mounter 10, component transfer device 50 is provided (paper front direction) above board conveyance device 20. For example, component transfer device 50 is an XY robot type device. Component transfer device 50 includes first frame 51 which extends along the Y-axis direction, second frame 52 which extends along the X-axis direction, support base 53, mounting head 54, cylindrical suction nozzle 55, and imaging device 56.

First frame 51 is provided on base 11 so as to be movable along the X-axis direction. Second frame 52 is provided on first frame 51 so as to be movable along the Y-axis direction. Support base 53 is detachably provided on second frame 52. Mounting head 54 is provided on support base 53 so as to be lifted and lowered along a Z-axis direction orthogonal to the X-axis direction and the Y-axis direction. Suction nozzle 55 is provided to protrude downward from mounting head 54. A lower end of suction nozzle 55 sucks and holds the component or releases the sucked and held component. Imaging device 56 is for imaging board S and backup pin 31b from above, and the image data captured is output to control device 60.

In component transfer device 50, suction nozzle 55 can be exchanged with a holding nozzle (not illustrated) which holds backup pin 31b. Holding nozzle has a holding section (engaging section) which holds backup pin 31b, and the holding section detachably holds backup pin 31b.

Further, imaging device 13 is provided in base 11. Imaging device 13 monitors a state of the component picked up to suction nozzle 55, and image data indicating the state of the component monitored by imaging device 13 is output to control device 60.

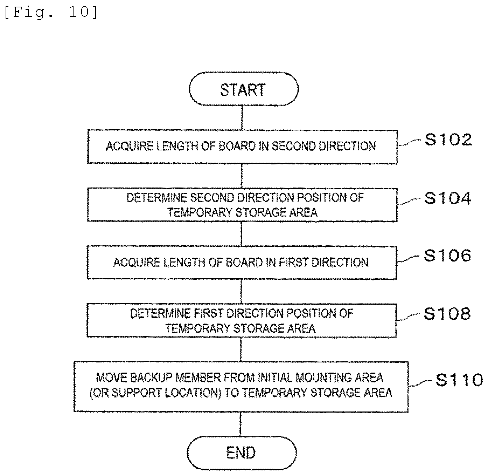

Control device 60 has a microcomputer (not illustrated), and the microcomputer includes an input/output interface, CPU, RAM, and ROM (all not illustrated) respectively connected to each other via a bus. The CPU executes a predetermined program to control mounting of the component on the board, and executes a program corresponding to a flowchart illustrated in Fig. 10 to determine a temporary storage location of backup pin 31b of backup device 30 of component mounter 10 or move backup pin 31b. The RAM temporarily stores a variable necessary for executing the program, and the ROM stores the program.

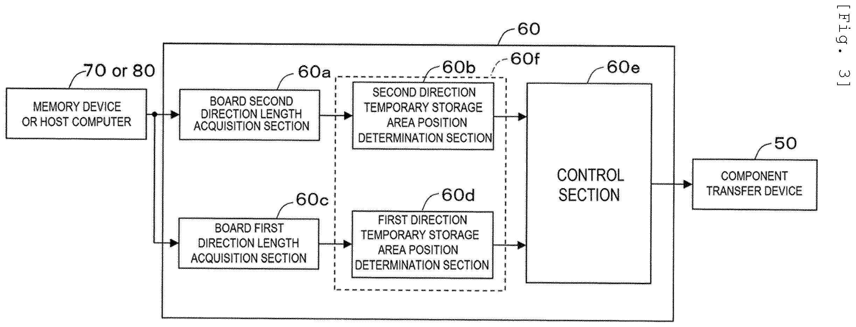

As illustrated in Fig. 3, control device 60 includes board second direction length acquisition section 60a, second direction temporary storage area position determination section 60b, board first direction length acquisition section 60c, first direction temporary storage area position determination section 60d, and control section 60e.

Board second direction length acquisition section 60a acquires a board second direction length, which is a length of board S in the second direction, from memory device 70 or host computer 80. Host computer 80 collectively manages multiple component mounters 10.

Second direction temporary storage area position determination section (hereinafter, may also be referred to as a second direction position determination section) 60b determines a second direction temporary storage area position (hereinafter, may also be referred to as a second direction position) which is a position of temporary storage area A1 in the second direction, based on the length of the board in the second direction received from board second direction length acquisition section 60a (determination section).

Temporary storage area A1 is an area set every time one new job is started (or every time a new group in which multiple jobs are grouped is started). Temporary storage area A1 is an area in which backup pin 31b can be temporarily placed (stored) before backup pin 31b is implanted when backup pin 31b is moved to a support position (implantation position) of backup pin 31b related to the job to be started. For example, when backup pin 31b of initial mounting area A2 is moved to the support position, temporary storage area A1 temporarily stores backup pin 31b of initial mounting area A2. Moreover, in a case where backup pin 31b at the old support position is moved to a new support position when one job is completed and the next job is started, temporary storage area A1 temporarily stores backup pin 31b which is not used at the new support position. Temporary storage area A1 is an area in which backup pin 31b, which is not used for one job, is temporarily stored during the job.

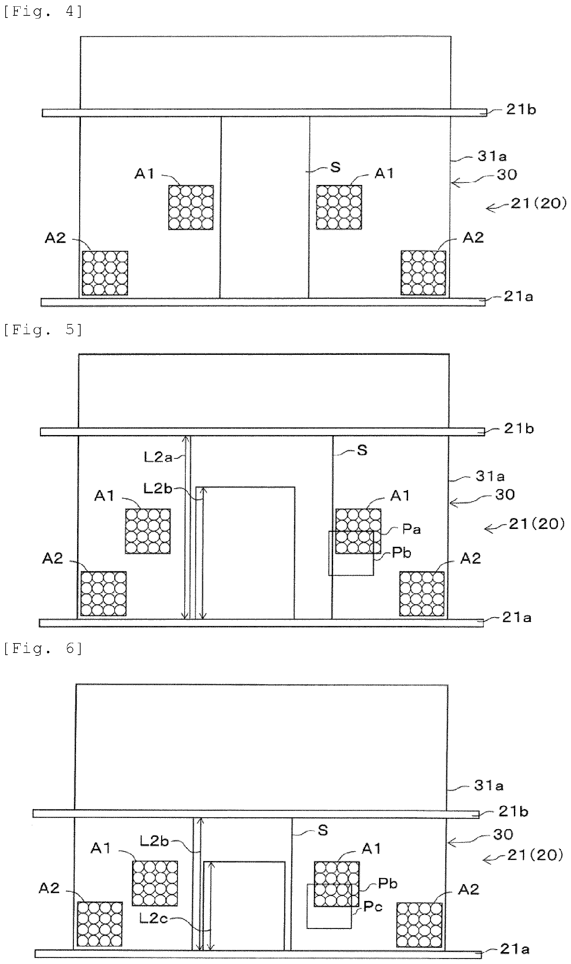

Initial mounting area A2 is a predetermined area where an operator initially (firstly) mounts backup pin 31b on facing surface 31a1 (backup device 30) of backup plate 31a. As illustrated in Fig. 4, initial mounting area A2 is set to a side of guide rail 21a, which is a side on which the operator mounts backup pin 31b, of pair of guide rails 21a and 21b. It is preferable that the initial mounting area A2 is provided at an end section (may be on both sides or on one side) of facing surface 31a1 along the first direction. In the present embodiment, initial mounting area A2 may be formed in a concave shape slightly lower than facing surface 31a1, or may be formed in a protruding shape slightly higher than facing surface 31a1 only in an outer peripheral section.

Initial mounting area A2 is a predetermined area is a place where the operator easily puts in and pulls out backup pin 31b. Therefore, the operator can mount backup pin 31b without hesitation, and thus operation easiness of the operation can be improved.

Further, as illustrated in Figs. 4 to 6, it is preferably that temporary storage areas A1 are provided on right and left sides (both sides along the first direction) of a board mounting position. The board mounting position is a position of board S to be positioned and fixed for mounting the component on board S. A hard type backup pin may be disposed in temporary storage area A1 on one side, and a soft type backup pin may be disposed in temporary storage area A1 on the other side. Hard type and soft type backup pins may be mixed in temporary storage areas A1 on both sides.

Moreover, temporary storage area A1 may be provided on either side.

Temporary storage area A1 is an area set on facing surface 31a1 of backup plate 31a. Temporary storage area A1 is an area (location, range) where backup pin 31b used for supporting board S can be temporarily stored when the component is mounted on board S. As illustrated in Fig. 4, temporary storage area A1 is an area in which backup pins 31b are aligned, and for example, in the present embodiment, temporary storage area A1 is a rectangular area arranged in 4 × 4 (four (four rows) backup pins 31b are arranged in the second direction and four (four rows) backup pins 31b are arranged) in the first direction. At this time, backup pins 31b adjacent to each other may be in contact with each other or may be disposed with a gap therebetween. Temporary storage area A1 may have another shape, for example, a circular area, or may have an indefinite shape. In addition, temporary storage area A1 is not limited to 4×4, and may be 8×2 in which eight backup pins 31b are arranged in the second direction and two backup pins 31b are arranged in the first direction, or may be 2 × 8 in which two backup pins 31b are arranged in the second direction and eight backup pins are arranged in the first direction.

In a case where the length of board S in the second direction is longer than a length of temporary storage area A1 in the second direction, second direction position determination section 60b determines the position of temporary storage area A1 in the second direction such that a center of temporary storage area A1 in the second direction coincides with a center of board S in the second direction. Accordingly, temporary storage area A1 is determined to a center section of board S in the second direction and it is possible dispose backup pin 31b before being located at the support position (implantation position) in the center section of board S in the second direction. Further, in general, in order to suppress bending of board S in the second direction, in most case, the support position of backup pin 31b is located at the center section of board S in the second direction. Therefore, it is possible to shorten a movement distance of backup pin 31b located in temporary storage area A1 from temporary storage area A1 to the support position (particularly, a support position located in the center section of board S in the second direction). As a result, it is possible to shorten a disposition time to the support position of backup pin 31b.

Specifically, for example, second direction position determination section 60b calculates coordinates of the center of board S in the second direction. Second direction position determination section 60b adds a value of a half of the length of temporary storage area A1 in the second direction to the coordinates of the center of board S in the second direction to calculate coordinates (coordinates of an end on second guide rail 21b side of temporary storage area A1 in the second direction) of one end of temporary storage area A1 in the second direction. Second direction position determination section 60b subtracts the value of the half of the length of temporary storage area A1 in the second direction from the coordinates of the center of board S in the second direction to calculate coordinates (coordinates of the end on first guide rail 21a side of temporary storage area A1 in the second direction) of the other end of temporary storage area A1 in the second direction. Then, second direction position determination section 60b may indicate the position of temporary storage area A1 in the second direction by the coordinates of one end and the coordinates of the other end of temporary storage area A1 in the second direction.

Second direction position determination section 60b may sort the length of the board in the second direction into multiple ranges divided in a stepwise manner, and the position of temporary storage area A1 in the second direction may be determined to setting positions which are set in a stepwise manner according to the respective ranges. For example, the respective ranges may be set to have values different by the length of temporary storage area A1 in the second direction. In this case, the setting positions are set in a stepwise manner apart by a value of a half of the length of temporary storage area A1 in the second direction.

Specifically, as illustrated in Fig. 5, for example, in a case where the length of board S in the second direction is in a range of L2a to L2b, the setting position is set to first setting position Pa. L2a is four times the length of temporary storage area A1 in the second direction. L2b is three times the length of temporary storage area A1 in the second direction. First setting position Pa is set at a board center in the second direction of board S, of which the board length in the second direction being L2a. First setting position Pa is a position of temporary storage area A1 which is set such that the center of temporary storage area A1 is separated from first guide rail 21a along the second direction by a value twice the length of temporary storage area A1 in the second direction. First setting position Pa may be set at the board center in the second direction of board S, of which the board length in the second direction being L2b.

As illustrated in Fig. 6, in a case where the length of the board in the second direction is in a range from L2b to L2c, the setting position is set to second setting position Pb. L2c is twice the length of temporary storage area A1 in the second direction. Second setting position Pb is set at the board center in the second direction of board S of which the board length in the second direction is L2b. Second setting position Pb is a position of temporary storage area A1 which is set such that the center of temporary storage area A1 is separated from first guide rail 21a along the second direction by a value of 1.5 times the length of temporary storage area A1 in the second direction. Moreover, the Y coordinate on second guide rail 21b side of temporary storage area A1 located at the second setting position Pb is the same as the Y coordinate on second guide rail 21b side of board S of which the board length in the second direction is L2c. Second setting position Pb may be set at the board center in the second direction of board S, of which the board length in the second direction being L2b.

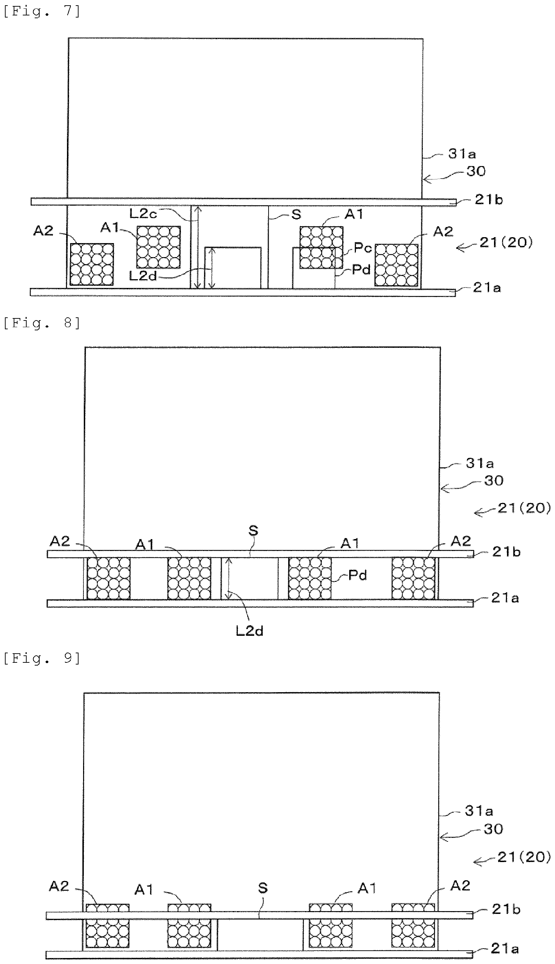

As illustrated in Fig. 7, in a case where the length of the board in the second direction is in a range from L2c to L2d and the end on second guide rail 21b side of board S exceeds the end on second guide rail 21b side of third setting position Pc (described later) to second guide rail 21b side, the setting position is set to third setting position Pc. Length L2d is the same as the length in the second direction of the smallest board on which component mounter 10 can mount the component. In the present embodiment, L2d has the same length as that of temporary storage area A1 in the second direction. Third setting position Pc is a position of temporary storage area A1 which is set such that the center of temporary storage area A1 is separated from first guide rail 21a along the second direction by the same value as the length of temporary storage area A1 in the second direction. Third setting position Pc may be set at the board center in the second direction of board S, of which the board length in the second direction being L2c.

In addition, in a case where the length of the board in the second direction is in the range from L2c to L2d and the end on second guide rail 21b side of board S does exceed the end on second guide rail 21b side of third setting position Pc, it is preferable that the setting position is set as follows. For example, the length of temporary storage area A1 in the second direction is set to a smaller value (for example, the length in the second direction is changed to half). (for example, 2 × 8)), and thus, the end on second guide rail 21b side end of the new setting position can be set so as not to exceed the end on second guide rail 21b side of board S. Further, simply by moving the new setting position in the second direction, the end on second guide rail 21b side of the new setting position may be set so as not to exceed the end on second guide rail 21b side of board S.

As illustrated in Fig. 8, in a case where the length of the board in the second direction is L2d, the setting position is set to fourth setting position Pd. Fourth setting position Pd is a position of temporary storage area A1 which is set such that the center of temporary storage area A1 is separated from first guide rail 21a along the second direction by a value of the half of the length of temporary storage area A1 in the second direction.

In a case where the length of temporary storage area A1 in the second direction is larger than the smallest length in the second direction of the board on which component mounter 10 can mount the component, when the length of board S in the second direction is equal to or less than the length of temporary storage area A1 in the second direction, the second direction position determination section 60b determines the position of temporary storage area A1 in the second direction such that temporary storage area A1 is positioned as close to first guide rail 21a side as possible. Fig. 9 illustrates a case where the length of board S in the second direction is smaller than the length of temporary storage area A1 in the second direction. Thus, temporary storage area A1 is determined at the center section of board S in the second direction, and it is possible to dispose backup pin 31b at the center section of board S in the second direction before backup pin is disposed at the support position. Therefore, it is possible to shorten a movement distance of backup pin 31b located in temporary storage area A1 from temporary storage area A1 to the support position (particularly, a support position located in the center section of board S in the second direction). As a result, it is possible to shorten a disposition time to the support position of backup pin 31b.

It is preferable that an area between first guide rail 21a and second guide rail 21b in temporary storage area A1 is used for placing backup pin 31b which is not used for supporting board S. It is preferable that temporary storage area A1 is set to be smaller than the length of board S in the second direction.

In addition, second direction position determination section 60b may determine the position of temporary storage area A1 in the second direction in consideration of not only the length of board S in the second direction for a single job (board product) but also the lengths of boards S in the second direction for multiple jobs. In this case, for example, when the lengths of boards S in the second direction of multiple jobs to be continuously produced are different from each other and are within a predetermined range (is a difference between the above-mentioned ranges and is the same value as the length of temporary storage area A1 in the second direction), the position of temporary storage area A1 in the second direction may be determined to be the same value. In a case where the lengths of boards S in the second direction of multiple jobs to be continuously produced are different from each other, the position of temporary storage area A1 in the second direction may be determined based on a value (for example, an average value and the most frequent value thereof) calculated from the lengths in the second direction.

According to this configuration, in a case where multiple jobs are continuously produced, it is not necessary to change the position of temporary storage area A1 for each job, and therefore, movement efficiency of backup pin 31b can be maintained high. For example, as compared with a case where the position of temporary storage area A1 is changed for each job, it is not necessary to move backup pin 31b, which is located in temporary storage area A1 and is not used for supporting board S, to new temporary storage area A1.

In this case, it is more preferable to also consider the lengths of boards S in the first direction of multiple jobs.

Board first direction length acquisition section 60c acquires the first direction length of the board, which is the length of board S in the first direction, from memory device 70 or host computer 80.

First direction temporary storage area position determination section (hereinafter, may also be referred to as a first direction position determination section) 60d determines a first direction temporary storage area position (hereinafter, may also be referred to as a first direction position) which is a position of temporary storage area A1 in the first direction, based on the length of the board in the first direction input from board first direction length acquisition section 60c (determination section). Similar to second direction position determination section 60b, first direction position determination section 60d determines the first direction position each time a new job is started (or each time a new group in which the multiple jobs are grouped) is started.

For example, the first direction position (an end on a side of temporary storage area A1 close to board S) is set so that temporary storage area A1 is disposed apart by a predetermined distance (for example, several millimeters) from both ends of board S in the first direction. The predetermined distance (minimum predetermined distance) is set in consideration of stopping accuracy of board S of board conveyance device 20. An end on a side of temporary storage area A1 remote from board S is a position separated from the end on the side of temporary storage area A1 close to board S by the length of temporary storage area A1 in the first direction. The first direction position can be indicated by XY coordinates with reference to a reference point (for example, a reference point of board S or a reference point of component mounter 10).

Further, the predetermined distance may be set to a value larger than the minimum predetermined distance. It is preferable that this value is set to a value in consideration of the operation easiness when the operator manually takes out backup pin 31b located at the support position.

Second direction temporary storage area position determination section 60b and first direction temporary storage area position determination section 60d constitute determination section 60f. Determination section 60f determines the position of temporary storage area A1, that is, the first direction position and the second direction position.

Control section 60e controls component transfer device 50 to move backup pin 31b between initial mounting area A2 and temporary storage area A1, and/or between the support position and temporary storage area A1. In this case, control section 60e acquires coordinate data of initial mounting area A2 or coordinate data indicating the support position from memory device 70 and host computer 80. Control section 60e acquires coordinate data (position information) of temporary storage area A1 from first direction position determination section 60d and second direction position determination section 60b. Control section 60e moves backup pin 31b based on the data.

Further, an operation of control device 60 which is the above-described temporary storage area position determination device will be described with reference to a flowchart illustrated in Fig. 10.

Control device 60 advances a program to Step S102 each time the job is started, and determines the position of temporary storage area A1. Specifically, in Step S102, control device 60 acquires the length of the board in the second direction from memory device 70 or host computer 80 by the processing of board second direction length acquisition section 60a described above. In Step S104, control device 60 determines the second direction position by the processing of second direction position determination section 60b described above.

Further, in Step S106, control device 60 acquires the length of the board in the first direction from memory device 70 or host computer 80 by the processing of board first direction length acquisition section 60c described above. In Step S 108, control device 60 determines the first direction position by the processing of first direction position determination section 60d described above.

Then, after control device 60 determines the position of temporary storage area A1, control device 60 controls component transfer device 50 by the processing of control section 60e described above to move backup pin 31b (Step S110).

According to the temporary storage area position determination device 60 of the above-described embodiment, determination section 60f determines the position of temporary storage area A1 in the second direction based on the length of board S in the second direction. Therefore, the position of temporary storage area A1 in the second direction can be set to an appropriate position (for example, the center section of board S in the second direction) of board S in the second direction, based on the length of board S in the second direction. As a result, a movement time of the backup member between temporary storage area A1 and the support position of backup pin 31b can be shortened.

Further, a temporary storage area determination method applied to backup device 30 described above will be described. The temporary storage area determination method is a temporary storage area position determination method for the backup device to determine the position of the temporary storage area A1 described above.

The temporary storage area position determination method includes a first step of determining the position of temporary storage area A1 in the second direction based on the length of board S in the second direction, and a second step of determining the position of temporary storage area A1 in the first direction based on the length of board S in the first direction. In the first step, the second direction position is determined by the processing of Step S104 (second direction position determination section 60b) described above. In the second step, the first direction position is determined by the processing of Step S108 (first direction position determination section 60d) described above.

Further, in the first step, preferably, the length of board S in the second direction is sorted into the above-described range divided in a stepwise manner, and the position of temporary storage area A1 in the second direction is determined to be the setting position which is set in a stepwise manner according to the range.

Further, in the first step, preferably, the position of temporary storage area A1 in the second direction is determined in consideration of the lengths of boards S in the second direction of the multiple jobs.

According to the temporary storage area position determination method for the backup device of the embodiment described above, in the first step, the position of temporary storage area A1 in the second direction is determined based on the length of board S in the second direction. Therefore, the position of temporary storage area A1 in the second direction can be set to an appropriate position (for example, the center section of board S in the second direction) of board S in the second direction, based on the length of board S in the second direction. As a result, a movement time of backup pin 31b between temporary storage area A1 and the support position of backup pin 31b can be shortened.

The temporary storage area determination device described above is control device 60 of component mounter 10, but host computer 80 which collectively manages multiple component mounters 10 may be the temporary storage area determination device. Host computer 80 may execute the temporary storage area determination method described above. In addition, the appropriate position of board S in the second direction is not limited to the center of board S in the second direction, and includes a position (for example, a position apart by a predetermined distance from the center in the second direction) near the center of board S in the second direction. For example, the predetermined distance can be set based on the length of the minimum board in the second direction, the length of the temporary storage area in the second direction, a deviation length along the second direction from a center in the second direction of a distribution (particularly, a distribution of backup pins 31b along the second direction) of backup pins 31b on board S, or the like.

### Reference Signs List

10: component mounter, 21a and 21b: pair of guide rails, 30: backup device, 31a1: backup plate, 31a: facing surface, 31b: backup member (backup pin), 60: temporary storage area position determination device (control device), 60f: determination section, A1: temporary storage area, A2: initial mounting area, S: board, Sb: component mounting surface, Sa: support surface, S104: first step, S108: second step, X-axis direction: first direction, Y-axis direction: second direction.

## Claims

1. A temporary storage area position determination method for determining a position of a temporary storage area (A1) which is an area for temporarily storing a backup member (31b) used for supporting a board (S), when a component is mounted on the board (S), the method being applied to a backup device (30) of a component mounter (10) including a pair of guide rails (21a, 21b) extending along a first direction in which the board (S) is conveyed, the pair of guide rails (21a, 21b) being configured to be movable relatively to each other along a second direction orthogonal to the first direction, and the backup device (30) configured to support the board (S) from a support surface (Sa) on a side opposite to a component mounting surface (Sb) on which the component is to be mounted, when the component is mounted on the board (S) conveyed by the pair of guide rails (21a, 21b), the backup device (30) including a backup plate (31a1) configured to reciprocate relatively to the support surface (Sa) of the board (S) while facing the support surface (Sa) of the board (S), and multiple backup members (31b), each of which being attachable to or detachable from a facing surface (31a) facing the support surface (Sa) of the board (S), which are configured to support the support surface (Sa) of the board (S), the method **characterized by**:
a first step for determining a second direction position, which is the position of the temporary storage area (A1) in the second direction, based on a length of the board (S) in the second direction, wherein the length of the board (S) in the second direction is sorted into a range divided in a stepwise manner, and the second direction position of the temporary storage area (A1) is determined to be a setting position set in a stepwise manner according to the range, wherein as the length of the board (S) in the second direction increases, the position of the temporary storage area (A1) is determined to be a position away from a first guide rail.

2. The temporary storage area position determination method according to claim 1,
wherein in the first step, the second direction position of the temporary storage area (A1) is determined in consideration of the length of the board (S) in the second direction of multiple jobs.

3. The temporary storage area position determination method according to claim 1 or 2, further comprising:
a second step for determining a first direction position which is the position of the temporary storage area (A1) in the first direction, based on a length of the board in the first direction.

4. The temporary storage area position determination method according to any one of claims 1 to 3,
wherein the backup plate (31a1) has an initial mounting area (A2) which is a predetermined area in which an operator initially mounts the backup member (31b) on the facing surface (31a) of the backup plate (31b),
the backup member (31b) mounted on the initial mounting area (A2) is movable to the temporary storage area (A1) by a component transfer device, and
the initial mounting area (A2) is set to a side of the guide rail, where the operator mounts the backup member, of the pair of guide rails (21a, 21b).

5. A temporary storage area position determination device (60) configured for determining a position of a temporary storage area (A1) which is an area for temporarily storing a backup member (31b) used for supporting a board (S), when a component is mounted on the board (S), the temporary storage area position determination device (60) being applied to a component mounter (10) including a pair of guide rails (21a, 21b) extending along a first direction in which a board (S) is conveyed, the pair of guide rails (21a, 21b) being configured to be movable relatively to each other along a second direction orthogonal to the first direction, and a backup device (30) configured to support the board (S) from a support surface (Sa) on a side opposite to a component mounting surface (Sb) on which the component is to be mounted, when the component is mounted on the board (S) conveyed by the pair of guide rails (12a, 21b), the backup device including a backup plate (31a1) configured to reciprocate relatively to the support surface (Sa) of the board (S) while facing the support surface (Sa) of the board (S), and multiple backup members (31b), each of which being attachable to or detachable from a facing surface (31a) facing the support surface (Sa) of the board (S), which are configured to support the support surface (Sa) of the board (S), the temporary storage area position determination device (60)
**characterized by**:
a determining section determining a second direction position, which is the position of the temporary storage area (A1) in the second direction, based on a length of the board (S) in the second direction, wherein the length of the board (S) in the second direction is sorted into a range divided in a stepwise manner, and the second direction position of the temporary storage area (A1) is determined to be a setting position set in a stepwise manner according to the range, wherein as the length of the board (S) in the second direction increases, the position of the temporary storage area (A1) is determined to be a position away from a first guide rail.

## Patentansprüche

1. Verfahren zur Bestimmung einer Position eines temporären Lagerungsbereiches, mit dem eine Position eines temporären Lagerungsbereiches (A1) bestimmt wird, der ein Bereich zum temporären Lagern eines Hilfselementes (31b) ist, das zum Tragen einer Platte (S) dient, wenn ein Bauteil an der Platte (S) montiert wird, wobei das Verfahren bei einer Hilfsvorrichtung (30) einer Bauteil-Montagevorrichtung (10) eingesetzt wird, die ein Paar von Führungsschienen (21a, 21b) enthält, die sich in einer ersten Richtung erstrecken, in der die Platte (S) transportiert wird, wobei die paarigen Führungsschienen (21a, 21b) so ausgeführt sind, dass sie relativ zueinander in einer zweiten Richtung orthogonal zu der ersten Richtung bewegt werden können, sowie die Hilfsvorrichtung (30), die so ausgeführt ist, dass sie die Platte (S) über eine Tragefläche (Sa) an einer Seite, die einer Bauteil-Montagefläche (Sb) gegenüberliegt, an der das Bauteil montiert werden soll, trägt, wenn das Bauteil an der durch die paarigen Führungsschienen (21a, 21b) transportierten Platte (S) montiert wird, wobei die Hilfsvorrichtung (30) eine Hilfsplatte (31a1), die so ausgeführt ist, dass sie sich relativ zu der Tragefläche (Sa) der Platte (S) hin- und herbewegt und dabei der Tragefläche (Sa) der Platte (S) zugewandt ist, sowie mehrere Hilfselemente (31b) enthält, von denen jedes an einer der Tragefläche (Sa) der Platte (S) zugewandten Fläche (31a) angebracht oder von dieser abgenommen werden kann, und die so ausgeführt sind, dass sie die Tragefläche (Sa) der Platte (S) tragen, wobei das Verfahren **gekennzeichnet ist durch:**
einen ersten Schritt zum Bestimmen einer Position in der zweiten Richtung, die die Position des temporären Lagerungsbereiches (A1) in der zweiten Richtung ist, auf Basis einer Länge der Platte (S) in der zweiten Richtung, wobei die Länge der Platte (S) in der zweiten Richtung in einen schrittweise unterteilten Bereich eingeordnet wird und die Position des temporären Lagerungsbereiches (A1) in der zweiten Richtung als eine Einstellposition bestimmt wird, die schrittweise entsprechend dem Bereich eingestellt wird, wobei, wenn die Länge der Platte (S) in der zweiten Richtung zunimmt, die Position des temporären Lagerungsbereiches (A1) als eine von einer ersten Führungsschiene entfernte Position bestimmt wird.

2. Verfahren zur Bestimmung einer Position eines temporären Lagerungsbereiches nach Anspruch 1,
wobei in dem ersten Schritt die Position des temporären Lagerungsbereiches (A1) in der zweiten Richtung unter Berücksichtigung der Länge der Platte (S) in der zweiten Richtung bei mehreren Aufträgen bestimmt wird.

3. Verfahren zur Bestimmung einer Position eines temporären Lagerungsbereiches nach Anspruch 1 oder 2, das des Weiteren umfasst:
einen zweiten Schritt zum Bestimmen einer Position in der ersten Richtung, die die Position des temporären Lagerungsbereiches (A1) in der ersten Richtung ist, auf Basis einer Länge der Platte in der ersten Richtung.

4. Verfahren zur Bestimmung einer Position eines temporären Lagerungsbereiches nach einem der Ansprüche 1 bis 3,
wobei die Hilfsplatte (31 a1) einen Anfangs-Montagebereich (A2) aufweist, der ein vorgegebener Bereich ist, in dem eine Bedienungsperson das Hilfselement (31b) am Anfang an der zugewandten Fläche (31a) der Hilfsplatte (31b) montiert,
das in dem Anfangs-Montagebereich (A2) montierte Hilfselement (31b) mittels einer Bauteil-Überführungsvorrichtung zu dem temporären Lagerungsbereich (A1) bewegt werden kann, und
der Anfangs-Montagebereich (A2) sich an einer Seite der Führungsschiene der paarigen Führungsschienen (21a, 21b) befindet, an der die Bedienungsperson das Hilfselement montiert.

5. Vorrichtung (60) zur Bestimmung der Position eines temporären Lagerungsbereiches, die ausgeführt ist zum:
Bestimmen einer Position eines temporären Lagerungsbereiches (A1), der ein Bereich zum temporären Lagern eines Hilfselementes (31b) ist, das zum Tragen einer Platte (S) dient, wenn ein Bauteil an der Platte (S) montiert wird, wobei die Vorrichtung (60) zur Bestimmung der Position eines temporären Lagerungsbereiches bei einer Bauteil-Montagevorrichtung (10) eingesetzt wird, die ein Paar von Führungsschienen (21a, 21b) enthält, die sich in einer ersten Richtung erstrecken, in der eine Platte (S) transportiert wird, wobei die paarigen Führungsschienen (21a, 21b) so ausgeführt sind, dass sie relativ zueinander in einer zweiten Richtung orthogonal zu der ersten Richtung bewegt werden können, sowie eine Hilfsvorrichtung (30), die so ausgeführt ist, dass sie die Platte (S) über eine Tragefläche (Sa) an einer Seite, die einer Bauteil-Montagefläche (Sb) gegenüberliegt, an der das Bauteil montiert werden soll, trägt, wenn das Bauteil an der durch die paarigen Führungsschienen (21a, 21b) transportierten Platte (S) montiert wird, wobei die Hilfsvorrichtung (30) eine Hilfsplatte (31a1), die so ausgeführt ist, dass sie sich relativ zu der Tragefläche (Sa) der Platte (S) hin- und herbewegt und dabei der Tragefläche (Sa) der Platte (S) zugewandt ist, sowie mehrere Hilfselemente (31b) enthält, von denen jedes an einer der Tragefläche (Sa) der Platte (S) zugewandten Fläche (31a) angebracht oder von dieser abgenommen werden kann, und die so ausgeführt sind, dass sie die Tragefläche (Sa) der Platte (S) tragen, wobei die Vorrichtung (60) zur Bestimmung der Position eines temporären Lagerungsbereiches
**gekennzeichnet ist durch:**
einen Bestimmungs-Teilabschnitt, der eine Position in der zweiten Richtung, die die Position des temporären Lagerungsbereiches (A1) in der zweiten Richtung ist, auf Basis einer Länge der Platte (S) in der zweiten Richtung bestimmt, wobei die Länge der Platte (S) in der zweiten Richtung in einen schrittweise unterteilten Bereich eingeordnet wird und die Position des temporären Lagerungsbereiches (A1) in der zweiten Richtung als eine Einstellposition bestimmt wird, die schrittweise entsprechend dem Bereich eingestellt wird, wobei, wenn die Länge der Platte (S) in der zweiten Richtung zunimmt, die Position des temporären Lagerungsbereiches (A1) als eine von einer ersten Führungsschiene entfernte Position bestimmt wird.

## Revendications

1. Procédé de détermination de position d'une zone de stockage temporaire destiné à déterminer la position d'une zone de stockage temporaire (A1), qui est une zone pour stocker temporairement un élément de soutien (31b) utilisé pour supporter une carte (S), quand un composant est monté sur la carte (S), le procédé étant appliqué à un dispositif de soutien (30) d'un dispositif de montage de composants (10) comportant une paire de rails de guidage (21a, 21b) qui s'étendent dans une première direction de convoyage de la carte (S), les rails de la paire de rails de guidage (21a, 21b) étant configurés pour être mobiles l'un par rapport à l'autre selon une deuxième direction orthogonale à la première direction, et le dispositif de soutien (30) étant configuré pour supporter la carte (S) à partir d'une surface de support (Sa) sur un côté opposé à une surface de montage de composants (Sb) sur laquelle le composant doit être monté, quand le composant est monté sur la carte (S) convoyée par la paire de rails de guidage (21a, 21b), le dispositif de soutien (30) comprenant une plaque de soutien (31a1) configurée pour effectuer un mouvement de va-et-vient par rapport à la surface de support (Sa) de la carte (S) tout en faisant face à la surface de support (Sa) de la carte (S), et de multiples éléments de soutien (31b), qui peuvent chacun être attachés à ou détachés d'une surface opposée (31a) qui fait face à la surface de support (Sa) de la carte (S), configurés pour supporter la surface de support (Sa) de la carte (S), le procédé étant **caractérisé par** :
une première étape de détermination d'une deuxième position de direction, qui est la position de la zone de stockage temporaire (A1) dans la deuxième direction, sur la base d'une longueur de la carte (S) dans la deuxième direction, dans lequel la longueur de la carte (S) dans la deuxième direction est classée dans une plage divisée de manière échelonnée, et la deuxième position de direction de la zone de stockage temporaire (A1) est déterminée comme étant une position de réglage établie de manière échelonnée selon la plage, dans lequel, lorsque la longueur de la carte (S) augmente dans la deuxième direction, la position de la zone de stockage temporaire (A1) est déterminée comme étant une position éloignée d'un premier rail de guidage.

2. Procédé de détermination de position d'une zone de stockage temporaire selon la revendication 1,
dans lequel, dans la première étape, la position dans la deuxième direction de la zone de stockage temporaire (A1) est déterminée en tenant compte de la longueur de la carte (S) dans la deuxième direction de multiples tâches.

3. Procédé de détermination de position d'une zone de stockage temporaire selon la revendication 1 ou 2, comprenant en outre :
une deuxième étape de détermination d'une première position de direction, qui est la position de la zone de stockage temporaire (A1) dans la première direction, sur la base d'une longueur de la carte dans la première direction.

4. Procédé de détermination de position d'une zone de stockage temporaire selon l'une quelconque des revendications 1 à 3, dans lequel
la plaque de soutien (31a1) comporte une zone de montage initiale (A2), qui est une zone prédéterminée dans laquelle un opérateur monte initialement l'élément de soutien (31b) sur la surface opposée (31a) de la plaque de soutien (31b),
l'élément de soutien (31b) monté sur la zone de montage initiale (A2) est mobile vers la zone de stockage temporaire (A1) grâce à un dispositif de transfert de composants, et
la zone de montage initiale (A2) est établie sur un côté du rail de guidage, où l'opérateur monte l'élément de soutien, de la paire de rails de guidage (21a, 21b).

5. Dispositif de détermination de position d'une zone de stockage temporaire (60) configuré pour déterminer la position d'une zone de stockage temporaire (A1), qui est une zone pour stocker temporairement un élément de soutien (31b) utilisé pour supporter une carte (S), quand un composant est monté sur la carte (S), le dispositif de détermination d'une position de zone de stockage temporaire (60) étant appliqué à un dispositif de montage de composants (10) comprenant une paire de rails de guidage (21a, 21b) s'étendant selon une première direction dans laquelle une carte (S) est convoyée, les rails de la paire de rails de guidage (21a, 21b) étant configurés pour être mobiles l'un par rapport à l'autre selon une deuxième direction orthogonale à la première direction, et un dispositif de soutien (30) configuré pour supporter la carte (S) à partir d'une surface de support (Sa) sur un côté opposé à une surface de montage de composants (Sb) sur laquelle le composant doit être monté, quand le composant est monté sur la carte (S) convoyée par la paire de rails de guidage (12a, 21b), le dispositif de soutien comprenant une plaque de soutien (31a1) configurée pour effectuer un mouvement de va-et-vient par rapport à la surface de support (Sa) de la carte (S) tout en faisant face à la surface de support (Sa) de la carte (S), et de multiples éléments de soutien (31b), qui peuvent chacun être attachés à ou détachés d'une surface opposée (31a) qui fait face à la surface de support (Sa) de la carte (S), configurés pour supporter la surface de support (Sa) de la carte (S), le dispositif de détermination de position d'une zone de stockage temporaire (60) étant **caractérisé par** :
une section de détermination qui détermine une deuxième position de direction, qui est la position de la zone de stockage temporaire (A1) dans la deuxième direction, sur la base d'une longueur de la carte (S) dans la deuxième direction, dans lequel la longueur de la carte (S) dans la deuxième direction est classée dans une plage divisée de manière échelonnée, et la deuxième position de direction de la zone de stockage temporaire (A1) est déterminée comme étant une position de réglage établie de manière échelonnée selon la plage, dans lequel, lorsque la longueur de la carte (S) augmente dans la deuxième direction, la position de la zone de stockage temporaire (A1) est déterminée comme étant une position éloignée d'un premier rail de guidage.
